# EUROPEAN PATENT APPLICATION

(11) **EP 4 177 935 A1**
(43) Date of publication of application: **10.05.2023**
(21) Application number: 21206287.1
(22) Date of filing: 03.11.2021
(51) Int. Cl.: H01L 21/50, H01L 23/10, H01L 23/26

(54) **HERMETIC LASER-WELDED ENCLOSURE**

(71) Applicant: SCHOTT AG, 55122 Mainz (DE)
(72) Inventor: THOMAS, Dr. Jens Ulrich, 55128 Mainz (DE); MÄÄTTÄNEN, Antti, 33710 Tampere (FI); LUNDEN, Heidi, 33720 Tampere (FI); POLOJÄRVI, Dr. Ville, 33710 Tampere (FI); ZETTERER, Dr. Thomas, 84034 Landshut (DE); NATTERMANN, Dr. Kurt, 55437 Ockenheim (DE)
(74) Representative: Blumbach · Zinngrebe Patentanwälte PartG mbB

(57) **Abstract**

A hermetically sealed enclosure is shown, comprising at least a first substrate and a second substrate, a function zone that is circumferentially enclosed in the enclosure, wherein the second substrate is transparent at least in part and/or at least for a bandwidth of wavelengths, at least one laser weld line to hermetically weld the substrates of the enclosure with each other and/or to hermetically seal the function zone, and at least one reduction zone for reducing an amount of molecules in the function zone.

## Description

### Field of the Invention

The invention is related to an enclosure, for example, for providing a hermetically sealed compartment in at least two layers of substrates, as well as a manufacturing process for making the same.

### Background and Summary of the Invention

Enclosures can be used, for example, to protect electronics, circuitry or sensors. It is possible to use hermetically sealed implementations of aforementioned enclosures for medical implants, for example, in a therapy to cure a heart disease, or, for example, in a retina or for any type of bio-processor. Known are bio-processors, which are made from titan.

Sensors can be protected by means of the invention, for example, for use in particular rough climate conditions. Further examples are Micro-Electro-Mechanic-Systems (MEMS), a pressure sensor, blood gas sensor, a glucose meter, such as a blood glucose meter, or the like.

Further fields of usage for the present invention can be found in protection sleeves for cell phones, in the field of virtual reality and augmented reality goggles and headsets and similar devices. For example, the invention may also be used in the scope of electromobility; But also in aviation and space environment, in high temperature environments and in the field of micro optics the invention might be used.

The aforementioned applications all concern devices faced with rough environmental conditions and which thus have to be designed especially robust - or protected from these conditions. For example, in order to allow for the use of any electronics, which may be expected not to survive the aforementioned environmental conditions, but which may be made cheaper or where even no rough electronics exist which could withstand in this conditions, the invention may be used to protect such devices like electronics.

Further, the invention may allow to some extent an exchange or way of communication with the inner region of the device according to the invention, e.g., the enclosure, or the cavity situated inside the enclosure. This exchange or way of communication can be realized, e.g., by means of electromagnetic radiation, e.g., in visible light region and/or in the region of microwave radiation. For realization of the same, the enclosure is, at least in part and/or at least for a range of wavelengths, transparent. This transparency allows for communication methods, for any kind of data or energy transmission, and for measurements with and by electronics or sensors situated inside a cavity. In particular, optical communication methods or optical data or energy transmission is possible.

However, implementing a cavity in the enclosure is only an embodiment for possible usages of the invention. As well be understood below, the invention is not limited to enclosures with cavities, but nevertheless the preferred usage is for improving enclosures having cavities.

It is principally known to provide several parts or layers and to arrange them such that in an inner region components can be situated. For example European Patent EP 3 012 059 B1 shows a method for manufacturing a transparent component for protecting an optical component. A new laser welding method is used therein.

The layers to be used can all be glass or glass-like substrates, but it gets also increasingly interesting to combine different materials with each other, like metal and glass or epoxy resin, or other silicon-containing materials.

Regarding such enclosures, it is an object of the invention to improve long-term reliability of devices or function zones enclosed in the enclosure.

It is another object of the invention to provide an enclosure which may be designed even smaller, as less or no additional layer(s) and/or less or no additional material(s) might be necessary, in order to design the enclosure as small as it gets.

As a background information about the present invention and, at the same time, to describe the motivation behind the present disclosure, it was identified in the course of the present invention, that moisture in the enclosure might be a problem, at least in the long term, for any device installed inside the enclosure, or when environmental moisture level changes. For example, typical enclosures are assembled in a clean room, but relative or absolute level of moisture in the air may not be regulated in a clean room. Or in other words, albeit the fact that air temperature and thereby the maximum possible humidity levels inside a cleanroom may be tightly controlled, the absolute values may vary between different countries, or between specifications of different factories. For some components like OLED layers, moisture is especially detrimental.

A total control of the humidity of a cleanroom is energy consuming and thereby relevant for the control of greenhouse gases and/or the availability of sustainable energy. This becomes especially relevant for locations with higher outside temperature and/or humidity. So it may be the case that upon assembly a relatively high level of moisture is present in the air of the cleanroom, which is enclosed in the enclosure upon hermetically sealing the same.

The moisture content of H₂O in a volume of air may typically be in a range of about 1,000 ppm to 50,000 ppm (parts per million) of H₂O, depending, for example, on the current meteorological conditions and temperature. For example, in air at a temperature of -20°C the moisture content in volume in the air is about 1,000 ppm, corresponding to a water vapour pressure in the air of about 100 Pa, or an absolute humidity of 0.88 g/m³. Further, in air at a temperature of +30°C the moisture content in volume in the air is about 30,000 ppm, corresponding to a water vapour pressure of about 4.200 Pa, or an absolute humidity of 30.4 g/m³.But even the comparatively low moisture levels of 1,000 ppm in dried air and/or in very cold air may be too high for sensitive electronics and/or for long-term durability.

Another aspect addressed by the present disclosure could include any amounts of undesired gas, such as including substances, such as generated by means of outgassing from electronics, circuit board, components and/or sensor elements sealed inside the enclosure. Such undesired gas or substance, like the before-mentioned outgassing, could be separated, trapped, embedded or enclosed in a specific region (i.e. the reduction zone as described hereinbelow).

Therefore, the present invention may be seen in the vicinity of improving known enclosures, e.g., regarding reliability and/or robustness of enclosures regarding environmental conditions, energy savings and improving traceability and/or size of such an enclosure.

The object of the invention is achieved by subject matter of the independent claims. Preferred embodiments of the invention are subject of the dependent claims.

A hermetically sealed enclosure, according to the invention, comprises at least a first substrate having an inner surface and a second substrate having an inner surface. The first substrate and the second substrate are arranged next to each other in such a way that the inner surface of the first substrate is positioned adjacent to the inner surface of the second substrate. In other words, the two substrates are arranged next to each other, i.e., in direct proximity to one another, wherein the inner surface plane of the first substrate is in contact with the inner surface plane of the second substrate.

Typically, each substrate of the enclosure is comprised in a rather flat form, so that the outer surfaces of the substrates as well as the inner surfaces opposing the outer surfaces comprise comparably longer dimensions than the circumferential rim, which lies in between the outer surfaces. Again, typically, the inner surface of each substrate may be aligned parallel to the respective outer surface, but if a certain effect may be obtained from it, also an angle may be present in between the plane of the inner surface and the plane of the outer surface.

By aligning several, at least two, substrates next to or over one another, a stack of substrates is formed. Such a stack of substrates may then be laser-welded in order to firmly join the substrates with each other. For example, for each two substrates, one laser weld line may be used for joining these two substrates. Therefore, for example, in the case that four substrates shall be used to form the enclosure, three laser weld lines may be introduced, where each laser weld line is arranged such to join the respectively two neighboring substrates of the substrate stack.

At least the top most substrate, e.g., the second substrate, preferably comprises transparent material and/or is transparent at least in part of its surface or volume and/or at least for a bandwidth of wavelengths, e.g. for a range from 1020 nm to 1070 nm. Whenever the laser is used for welding and joining the substrates to each other, the laser therefore can pass through the second substrate in order to e.g. reach the interface zone in between the two substrates to be welded.

The hermetically sealed enclosure comprises a function zone that is circumferentially enclosed in the enclosure. Such a function zone may comprise, for instance, a cavity and/or may comprise one or more devices or components to be enclosed inside the enclosure and thus be protected from the environmental conditions outside the enclosure. For example, the function zone may comprise some detector means, some microelectronic or mechanical system and/or any micro optics. Even an energy-harvesting device such as a small solar cell may be provided in the function zone. In other words, a cavity is one embodiment of a function zone, wherein the function zone may be composed, on one example, of a cavity and some electronic component arranged inside the cavity. The function zone may also, in another example, be comprised of an electronics layer, such as a layer of photoreceptive diodes.

The hermetically sealed enclosure according to the invention comprises further at least one laser weld line to hermetically weld the substrates of the enclosure with each other and/or to hermetically seal the function zone. For example, a laser weld line may be drawn without gap around the function zone, so that the first substrate is hermetically joined to the second substrate.

The laser weld line typically comprises a series of laser dots in a sequence. These laser dots may be placed close enough to each other so that they overlap and thus form a continuous laser weld line. Such a continuous laser weld line produced by a series of laser dots comprises hermetically sealing properties, for example, when it is drawn around the function zone. By means of the laser weld line, the substrates are firmly joined with each other in that the laser weld line melts or mixes the material of the first substrate with material of the second substrate in a "convection zone", in that the laser dot is placed such that the aforementioned mixture of materials is achieved.

For example, the at least one laser weld line may comprise a first separation spacing S1 to the outer surface of the first substrate and a second separation spacing S2 to the outer surface of the second substrate, and/or may be arranged such that it comprises a third separation spacing S3 to the circumferential rim of the enclosure. In other words, the laser weld line may provide a secure spacing to the outer surfaces of the first or second substrate, respectively, or to the circumferential rim so that neither of these boundary parts of the enclosure interfere with the laser weld line. Such a spacing may be called a "tolerance zone". Typically, the enclosure is diced out of the wafer or a waferstack, so that additional spacing in between the laser weld line and the rim can be advantageous in that the laser weld line is not affected upon dicing the enclosure out of the waferstack.

The laser weld line may directly bind the first and second substrate to each other in the case that the first substrate and the second substrate are positioned directly adjacent each other and the laser weld line is meant to join these two substrates with each other by means of a direct laser-induced welding process.

The at least one laser weld line may extend from within the first substrate to within the second substrate and may permanently join the first substrate to the second substrate. This may be provided by either a laser weld line specifically introduced to join the two substrates, or there may be provided several laser weld lines to join either the first and the second substrate with each other, or, to join several substrates to the respective adjacent substrate. The laser weld line joining the first and the second substrate therefore may comprise a mixture of material of the first substrate and the second substrate. The mixture is established during introduction of the laser spot, where convection of the material takes place above the laser spot, as the material is melted and mixed. In other words, in the laser weld line, material from the first substrate may be mixed into the second substrate and vice versa, namely, material from the second substrate may also be mixed into the first substrate. In the laser weld line, a convection zone may be present which is characterized in that material from the first substrate is mixed with material from the second substrate in the convection zone.

The laser weld line typically comprises a height HL in a direction perpendicular to its connecting plane. The laser weld line may be situated with a height HL1 inside the first substrate and with a height HL2 = HL - HL1 inside the second substrate. In other words, the total laser weld line height HL is situated partly inside the first substrate or the second substrate, which means that no additional material or spacing is present in between the first substrate and the second substrate. This indicates that the first substrate is directly bonded and mixed with the second substrate by means of the laser weld process. When the laser weld line is equally reaching into both substrates, that is HL1 = HL2, the bigger volume part of the convection zone is situated inside the uppermost substrate. If the laser weld line is shot deeper into the first substrate, which is the lowermost substrate, then HL1 is greater than HL2. Still, the sum of HL1 + HL2 preferably adds up to HL.

The at least one laser weld line may circumference the function zone in a distance DF, where the distance may correspond, for example, to the height HL or less. The distance DF may also correspond to double the height HL or less.

The function zone is typically arranged on the inner side of the first and/or second substrate. In case of an enclosure with two substrates, the function zone may also be arranged on the inner side of the first substrate as well as on the inner side of the second substrate. The function zone may comprise at least one cavity. The cavity may, for example, be arranged in the plane of the first and/or second substrate, by way of example, the cavity may be excavated from the first substrate and/or from the second substrate, for example by means of an abrasive method. In the case that three substrates are used to provide the enclosure, the uppermost and lowermost substrate may also be continuous substrates, where the function zone or cavity is arranged in the plane of the intermediate substrate. For example, the intermediate substrate can comprise holes, which become the cavity when the three substrates are stacked on one another to form a substrate stack.

There may at least be one functional component arranged inside the cavity, such as an electronic component, a MEMS or MOEMS.

The hermetically sealed enclosure according to the invention provides at least one reduction zone for reducing an amount of molecules in the function zone. The molecules to be reduced in the function zone may be one of gasses, e.g. which evaporate from electronics components in the function zone, or water, where water may be present as hydrogen, in liquid form or moisture, which is, the humidity in the function zone.

In other words, the reduction zone is comprised of an area facing towards the function zone and providing the capability of reducing a level of molecules in the function zone. By way of example, the molecules such as hydrogen, water or moisture in the function zone may be attracted by the reduction zone so that the molecules in the function zone are forced to enter the reduction zone and thus, in turn, are forced to leave the function zone. For example, the reduction zone provides for introduction of a lower equilibrium of moisture content for the function zone. Further by way of example, the at least one reduction zone may be designed to catch molecules such as hydrogen, water or moisture out of the function zone. The at least one reduction zone may be designed as a trap or net for said molecules so that, e.g., any gaseous or liquid amount of water present in the function zone upon contact with the reduction zone is trapped on or inside the reduction zone. Therefore, in other words, the at least one reduction zone may also be described as hydrophilic.

The hydrophilic or hydrophobic surface property can be described by the wettability. The wettability of a surface can be measured with standardized methods, e.g. by the contact angle of a water droplet as described in ref (DIN EN ISO 19403-1:2020-04). The contact angle is the angle, conventionally measured through the liquid, where a liquid-vapor interface meets a solid surface. It quantifies the wettability of a solid surface by a liquid via the Young equation. A given system of solid, liquid, and vapor at a given temperature and pressure has a unique equilibrium contact angle. Typically, a highly wettable (hydrophilic) surface shows a rather small contact angle, whereas a less wettable (hydrophobic) surface shows a rather high contact angle. For this invention, hydrophilic surfaces were found to be beneficial to the self drying effect.

As the reduction zone may be prepared or described as hydrophilic, the reduction zone preferably shows a rather small contact angle. A contact angle of the surface in the reduction zone may thus be 20° or smaller, preferably 15° or smaller, further preferably 10° or smaller, or even 5° or smaller or even 3° or smaller.

The absolute amount of molecules to be reduced, such as water or moisture, and being present in the function zone is constantly reduced by interaction with the reduction zone. Reduction rate therefore is a function involving time. In an advantageous embodiment, the overall device is designed to comprise a reduction zone with dimensions being calculated so that the reduction zone can "bind" or "capture" sufficient enclosed components to be reduced, especially moisture. Due to the hermetical seal provided by the laser bondline, no further molecules can invade the component from the outside and a controlled setup is provided in the function zone, especially in the case that the function zone comprises or consists of a cavity.

For example, in order to estimate hermetic properties of the enclosure a leak test may be applied, such as using a gas such as helium. A hermetical seal of the enclosure may be achieved when in a pressure difference of 1 Bar between inside and outside of the enclosure the leak rate of the gas, such as helium, is 10⁻⁷ mbar x Is⁻¹ or less, preferably 10⁻⁸ mbar x Is⁻¹ or less, further preferably 1 10⁻⁹ x Is⁻¹ or less.

The reduction rate provided by the reduction zone for molecules to be reduced in the function zone, such as gasses or water (e.g. in the form of moisture), may be 0.1% or more of amount of molecules (gasses or water, such as in the form of moisture) actually present in the function zone per day. The reduction rate may preferably be 0.5% or more per day, further preferably 1 % or more per day, even further preferred 2 % per day, 3 % or more per day or even 5 % or more per day of the absolute amount of molecules (gasses or water) present in the function zone. For example, if reduction rate is 3 % per day of the actual molecules (such as gasses or water) present in the function zone and initial molecule rate is 30,000 ppm, then in the first 24 hours 900 ppm will be reduced (3 % of 30,000 ppm), whereas in the consecutive 24 hours 873 ppm will be reduced (3 % of remaining 29,100 ppm) and so on. In the same example, when 1,008 hours (42 days) have passed, in a time period of 24 hours 258 ppm will be reduced by means of the reduction zone (3% of remaining 8,350 ppm), and when 3000 hours (125 days) have passed, the reduction zone will reduce 21 ppm (3 % of remaining 666 ppm) in a time period of 24 hours. In other words, the reduction rate of molecules present in the function zone provided by the reduction zone may preferably be constant over time, but the absolute amount of molecules (such as gasses or water, the latter such as moisture) reduced by the reduction zone is decreasing over time - at least until saturation of the reduction zone. So yet in other words the reduction zone is designed such to provide a reduction for molecules (such as gasses or water) in the function zone, where the reduction rate is preferably constant over time.

When the first and/or second substrate comprise an inner surface, each inner surface may be facing towards the other inner surface. Each inner surface may also be facing towards the function zone. The at least one reduction zone may then be arranged on said inner surface of the first substrate and/or of the inner surface of the second substrate.

The reduction zone may constitute at least part of the inner surface of the first substrate and/or of the second substrate. In other words, the inner surface of one or all of the substrates of the enclosure may constitute themselves the reduction zone, so that for example moisture is drawn into the substrate and the respective substrate may then be described as a moisture reservoir. The reduction zone, when described as a reservoir, is provided in a rather empty form and is able to be filled with the molecules, such as hydrogen, water or moisture, present in the function zone.

The reduction zone may comprise a part of the volume of the first substrate and/or of the second substrate including at least a part of the inner surface of the first substrate and/or of the second substrate, respectively. This reduction zone or reduction volume can then be described as comprising a sponge-like shape or form, where said molecules (hydrogen, water or moisture) may enter the material of the reduction zone, e.g. on or in the first or second substrate providing the reduction zone, and said molecules (hydrogen, water or moisture) is captured in this sponge-like structure so that it sticks to material inside the sponge-like structure. Also in this case, said molecules (hydrogen, water or moisture) are removed from the function zone and thus the amount of said molecules (hydrogen, water or moisture) in the function zone is reduced.

In other words, improving the hydrophilic properties the reduction zone may comprise an increased effective surface. For increasing the effective surface the reduction zone may comprise structures augmenting its surface in comparison to a plain or non-structured surface. For example, the reduction zone may comprise nano- and/or microstructures. Examples for nano- and/or microstructures may include at least one of porous glass (such as SCHOTT CoralPore), micro- and nanostructured glass surfaces, or a hydrophilic nano-coating.

The reduction zone may also be comprised as a coating on the inner side of the first substrate and/or on the inner side of the second substrate. In other words, it is preferable that the reduction zone is facing towards the function zone and, further preferably, in direct contact with any part of the boundary of the function zone.

The reduction zone may be designed such to absorb said molecules (e.g. water vapor) from the function zone.

The reduction zone and/or reduction volume, if regarded as a three-dimensional reduction zone, may comprise unsaturated OH groups. By means of unsaturated OH groups, any amount of molecules (such as hydrogen, water or moisture) may stick to at least one of the unsaturated OH groups, thereby saturating the respective OH group and, at the same time, reducing the amount of said molecules (hydrogen, water or moisture) circulating freely in the function zone.

The hermetically sealed enclosure may be designed such that the reduction zone may be regenerated or reactivated or activated by means of heating up the reduction zone and/or the enclosure above a threshold temperature. The threshold temperature may be, for example, 50°C or higher, or 75°C or higher.

The reduction zone may, for example, be regenerated or reactivated or activated by means of fire polishing, dry etching, dry cleaning or plasma cleaning. Additionally, by way of example, the inner side of the first substrate and/or the inner side of the second substrate is regenerated or reactivated or activated by at least one of the aforementioned processes.

Regeneration or reactivation or activation of the reduction zone may increase its permeability for said molecules (hydrogen, water or moisture).

It is preferable that the reduction zone is provided and designed in such a way that the laser weld line may pierce through the reduction zone without affecting the positive effect of the reduction zone.

The function zone may circumferentially be surrounded by the reduction zone, wherein the reduction zone is arranged on at least the inner sides of the first and second substrates, and may additionally be arranged on the inner side of an intermediate substrate, if applicable.

The first substrate may, at least in a contact area, be in direct contact with the second substrate, for example a two-dimensional contact area. The first substrate may be in direct contact with the second substrate, for example in a region circumfering the function zone. If an intermediate substrate is provided, the first substrate is in direct contact with the intermediate substrate and the second substrate is in direct contact with the intermediate substrate. In such a case, two contact areas are provided, one in between the first substrate and the intermediate substrate and the other in between the second substrate and the intermediate substrate, and at least two separate laser weld lines are introduced to hermetically seal the function zone.

Advantageously, the function zone comprises at least one cavity. Such a cavity may comprise an amount of gas inside the cavity volume, where not only a specific gas such as a noble gas like helium can be used, but also the air of the cleanroom might be residually present in the cavity.

The reduction zone may be designed to reduce the content of said molecules (such as hydrogen, water and/or moisture) inside the function zone, or inside the cavity. Such a reduction of said molecules (hydrogen, water and/or moisture) content may be down to establishing a molecule content of 700 ppm (parts per million) or less, preferably down to 500 ppm or less, further preferably 250 ppm or less, or even down to 100 ppm or less. Typically, the non-reduced amount of molecules (hydrogen, water and/or moisture) in cleaned air may be in the region of 1,000 ppm up to 50,000 ppm.

The function zone of the enclosure may comprise 700 ppm or less of said molecule (hydrogen, water and/or moisture) content, preferably 500 ppm or less, further preferably 250 ppm or less, or even 100 ppm or less. It is understood that such a low partial amount of molecules (hydrogen, water and/or moisture) in the function zone or in the cavity is achieved by means of introducing the reduction zone according to the invention, in that the reduction zone is able to reduce amount of said molecule content (hydrogen, moisture or water) in at least one of the enclosure, function zone or cavity.

The present disclosure also provides usage of an hermetically sealed enclosure as described above for making a medical implant, a wafer-level packaged component, a microlens compound, a micro-optical chip, a pharmaceutical packaging, a sensor such as a LIDAR sensor, or an LED device, to give some examples.

The present disclosure also provides for a method of providing a hermetically sealed enclosure, for example as described above, wherein the enclosure encloses a function zone. The method comprises the steps providing a first substrate and a second substrate. It further provides the step preparing a reduction zone on or at the first substrate and/or the second substrate for reducing an amount of molecules (hydrogen, water or moisture) in the function zone. Alternatively, the method may provide the step of providing said reduction zone on or at the first substrate and/or the second substrate. There is provided the step aligning the first substrate with an inner side at an inner side of the second substrate. In other words, the first substrate is positioned adjacent to the second substrate and each inner surface is arranged to be in contact with each other.

Further, the method provides laser welding the first substrate to the second substrate by means of introducing at least one laser weld line in the enclosure, and in this step hermetically sealing the function zone.

The method as described herein may further comprise laser welding of the laser weld line by guiding a laser beam from a laser beam source such that the laser weld line is drawn around the function zone and in between the first substrate and the second substrate. The step may also provide for guiding the laser beam from the laser beam source such that it reaches both into the first substrate and the second substrate. Thereby, the first substrate is firmly and permanently welded to the second substrate.

The method as described herein may further comprise that the laser weld line is drawn by means of a pulsed laser source, so that a continuous or a quasi-continuous weld line is composed from several laser pulses. Spaced apart laser weld lines can be generated in that laser pulses are spaced apart from consecutive laser pulses. The introduction of the laser weld line hermetically seals the function zone by means of said laser weld line. Several laser weld lines may be drawn around the function zone, preferably comprising the cavity, in order to improve hermetically seal of the function zone.

In the step aligning the at least two substrates directly at each other, the first substrate may be in direct contact with the second substrate, for example in that at least 25 percent of the area of the inner side of the first substrate is in direct contact with the inner side of the second substrate. As mentioned above, the second substrate may comprise at least in part of its surface or volume and/or at least for a wavelength bandwidth a transparent material.

After the step of hermetically sealing the function zone, it is possible to further comprise the step of reducing the amount of molecules (hydrogen, water or moisture) in the function zone to an amount of 700 ppm or less, preferably 500 ppm or less, more preferably 250 ppm or less, or even 100 ppm or less.

Furthermore, the step of activating or reactivating or regenerating the reduction zone may be provided.

There may be provided the step of heating the enclosure above a threshold temperature, for example above room temperature or to a temperature above 50°C, preferably to a temperature of 75°C or more.

Either of the steps of activating or reactivating or regenerating the reduction zone or heating the enclosure above said threshold temperature may preferably be performed after the step of hermetically sealing the function zone.

The step of aligning the two substrates directly at each other such that the first substrate is in direct contact with the second substrate may be performed in a manner that no other material is arranged in between the first substrate and the second substrate. Such other material not necessary for the welding method described herein may include, for example,glass fritt or glue or any such additional bonding materials.

The description may also provide for an evacuated sealed enclosure made by the method as described hereinabove.

As a material for the first and/or second substrate, a variety of materials can be used, e.g., homogeneous glass or monocrystalline silicon, chemically hardened glass, even covered with an optical coating, glass or glass-like material, for example, glass ceramics or crystalline. Furthermore, silicone-based substrates can be used, where any of the aforementioned materials can be used in combination with each other.

The laser weld line is typically obtained by shooting a short pulsed laser beam from a laser source into the material with a defined wavelength and energy so that the series of laser beam spots is placed into the material of the enclosure. By placing the beam spots so close together that the resulting nonlinear absorption zone at least is in contact with the neighboring nonlinear absorption zone, or even overlaps with it, heat accumulation can occur that produces a continuous welding line.

In the direction perpendicular to its connecting plane, the laser weld line comprises said height HL. The connecting plane is the direction in which the neighboring or consecutive beam spots are set, for example, the contact plane of the inner surface of the first and second substrate. Typically, the laser welding is performed from an "overhead perspective", meaning that the substrate stack is positioned, e.g., on a surface, such as a table, and that the laser is shot from above at least through the uppermost substrate layer - or through more than one substrate layer - to the place of the beam focus. The height HL thus is measured in the direction of the laser beam, where the width of the laser weld line is measured perpendicular with respect to the direction of the laser beam. Although the top-down setup is preferred due to practicality, the inventive steps described forewidth can also be realized with a setup where the focussed laser beam is applied from the bottom or the side of the workpiece. So it is clear that directions or positions like "overhead" or "above", "below" are only indicated herein for reasons of raising clarity, to make the examples more figurative, but are not meant to be limiting the scope of protection in any respect. To the contrary, the present specification is not limited to such directions, where "overhead" can also be, e.g., "from below", and, exemplarily, substrates may be sorted in another arrangement, where a first substrate may be above or below a second substrate if it is not technically hindered for any reason indicated in the respective example given in this specification.

The invention is described in more detail and in view of preferred embodiments hereinafter. Reference is made to the attached drawings wherein like numerals have been applied to like or similar components.

### Brief Description of the Figures

It is shown in
- Fig. 1: a schematic cross-sectional side view of an enclosure according to the invention,
- Fig. 2: a schematic cross-sectional side view of an enclosure according to another embodiment,
- Fig. 3: a schematic top view of an enclosure,
- Fig. 4: a schematic cross-sectional side view of another embodiment of an enclosure,
- Fig. 5: a cross-sectional detail of the zone of laser of an embodiment of an enclosure,
- Fig. 6: a cross-sectional schematic of a laser spot zone in an enclosure,
- Fig. 7: an embodiment of a method of manufacturing an enclosure according to the invention,
- Fig. 8: another embodiment of a method of manufacturing an enclosure,
- Fig. 9: a photograph of an enclosure part,
- Fig. 10: a photograph of a multitude of enclosures,
- Fig. 11: another photograph of the multitude of enclosures,
- Fig. 12: graphical data of drying inside an enclosure according to the invention, and
- Fig. 13: another set of graphical data showing drying in an enclosure according to the invention.

### Detailed Description of the Invention

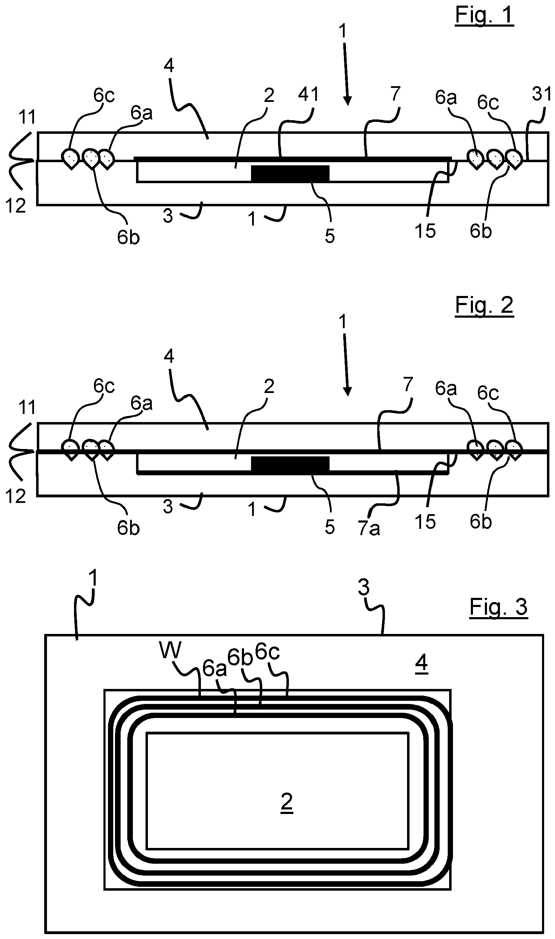

Regarding Figure 1, a cross-sectional view of an embodiment of an enclosure 1 is shown, where a bottom layer 3 is arranged underneath a top layer 4. The bottom layer or first substrate 3 and a top layer or second substrate 4 are hermetically bonded to each other by means of three laser weld lines 6a, 6b, 6c. The three laser weld lines 6a, 6b, 6c stretch into material of the first substrate 3 as well as into material of the second substrate 4, thus mixing the materials of the two substrates 3, 4. Introducing a firm seal between the substrates 3, 4, 4a, the laser weld lines 6a, 6b, 6c may provide a hermetically sealed area, where the laser weld lines 6a, 6b, 6c are drawn around this area. In this hermetically sealed area, a function zone 2 is arranged, wherein in this example the function zone 2 is composed as a cavity 2. The two substrates 3, 4 contact each other at the inner side 31 of the first substrate 3 and the inner side 41 of the second substrate 4. Both inner sides 31, 41 touch each other at the contact area 15.

The rim 12 of the glass stack including the edge 11 of the contact area 15 connects the first substrate 3 with the second substrate 4 and goes circumferentially around the enclosure. In the perspective of Figure 1, the rim 12 is orientated vertically, whereas the first substrate 3 and the second substrate 4 comprise a horizontal orientation. Typically, the rim 12 is orientated perpendicular to the plane of the substrates 3, 4.

At the inner side 41 of the second substrate 4 and facing towards the cavity 2, a reduction zone 7 is arranged. The reduction zone 7 may already be activated or be activated after completion of the enclosure 1, for example by means of heating the enclosure 1 above the threshold temperature. The rim 12 may connect the outer side of the second substrate 4 over edge 11 with the outer side of the first substrate 3, so that the total outer surface area of the enclosure 1 may be comprised by the outer side of the second substrate 4, the rim 12 and the outer side of the first substrate 3. In this embodiment, a component 5 is arranged in the cavity 2, wherein the component 5 may not be heated beyond a temperature, above which damage to the component 5 may be possible. Therefore, the enclosure may not be heated without limitation, in order to protect the component 5 from heat.

With respect to Figure 2, an embodiment of an enclosure 1 is shown, wherein additionally to the reduction zone 7 as shown in Figure 1 a second reduction zone 7a is provided on the bottom of the cavity 2. Again, the cavity 2 is hermetically sealed by means of three laser weld lines 6a, 6b and 6c. Although one laser weld line 6a might be sufficient to provide hermetically sealing to the cavity 2 inside the enclosure 1, by introducing several laser weld lines 6a, 6b and 6c, hermiticity or impermeability of the cavity 2 may be assured. Figure 3 shows an embodiment of an enclosure in an overhead perspective view, where three laser weld lines 6a, 6b and 6c are provided in a circumferential manner around the cavity 2.

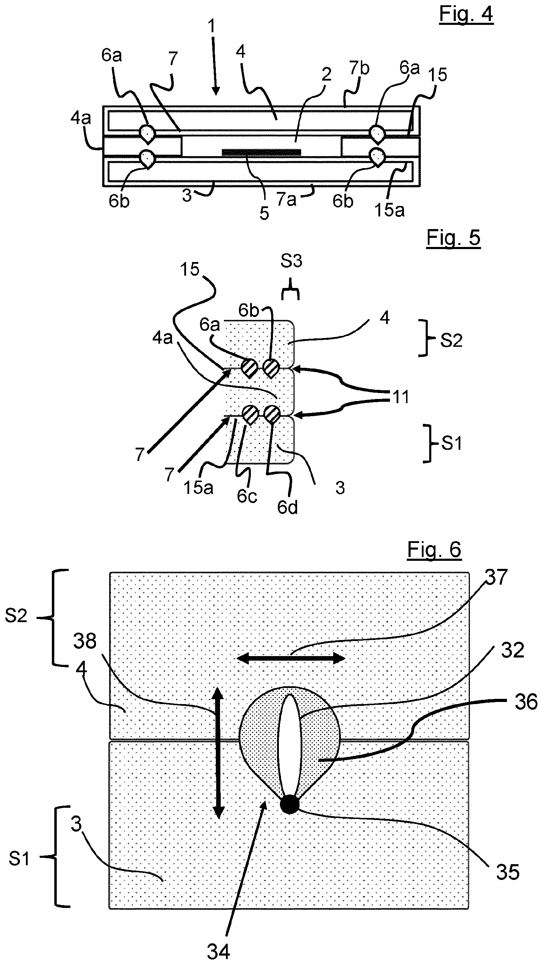

Referring now to Figure 4, an enclosure 1 is shown with a cavity 2, which is hermetically sealed by means of laser weld lines 6a and 6b. Laser weld line 6a is drawn in the contact area 15 in between the second substrate 4 and the intermediate substrate 4a, whereas second laser weld line 6b is drawn in second contact area 15a in between the intermediate substrate 4a and the first substrate 3. Both laser weld lines 6a, 6b circumference the cavity 2 and hermetically seal said cavity 2. First substrate 3 comprises the reduction zone 7a, which is situated on all surface areas of the first substrate 3. In other words, the first substrate 3 provides reduction capability on all surfaces 7a.Second substrate 4 of this embodiment provides a further reduction zone 7b on all of its surfaces. For example, second substrate 4 is a reduction substrate 7b and provides reduction capability on all of its surfaces 7b. For example, it may be easier to provide a substrate with reduction capability on all surfaces and weld such a substrate to the substrate stack of the enclosure so that, in the end, the inner side 31 of the first substrate 3 provides, facing towards the cavity 2, a reduction zone 7a, and at the same time, the second substrate 4 provides reduction zone 7 facing towards the cavity 2.

Figure 5 shows a detail perspective view of an embodiment of an enclosure comprising three substrates 3, 4, 4a, where each respective two substrates are welded together by means of each two laser weld lines 6a, 6b, 6c and 6d. Laser weld lines 6a and 6b are introduced in the contact area 15 between the second substrate 4 and the intermediate substrate 4a, whereas laser weld line 6c and 6d are introduced in second contact area 15a in between intermediate substrate 4a and first substrate 3. A reduction zone 7 is provided at each contact area 15, 15a facing towards the inner region of the enclosure 1, which is shown only partially in Figure 5. The laser weld lines 6a and 6b comprise a separation spacing S2 to the outer surface of the second substrate 4 and a third separation spacing S3 to the edge 11. Laser weld lines 6c and 6d provide a first separation spacing S1 to the outer surface of the first substrate 3 and a third separation spacing S3 to the edge 11. In total, all laser weld lines 6a, 6b, 6c, 6d are fully enclosed inside the enclosure 1.

With respect to Figure 6, a cross-sectional detail of a laser trace or laser spot is shown in more detail. A laser pulse generates a nonlinear absorption zone 35 and heat accumulation takes place in the direction of the laser pulse shot, which is in the direction to the above in the plane shown in Figure 6. Several distinct areas may be seen in Figure 6, where above the area of nonlinear absorption 35, which may correspond more or less with the laser focus and which may comprise a size of a few micrometers, and an elongated bubble-shaped region 32 may be formed, having only a few micrometers in width, but typically up to several tens of micrometer in height (it is also referred to as "bubble" (32) due to its typically quite characteristic shape comparable to an elongated bubble). Around that bubble-shaped region 32 there is situated a melting region 36 with a width indicated with arrow 37 and a height indicated with arrow 38, wherein temperatures above Tg may be reached in the glass or in the material of the respective substrate 3, 4. The material therefore has resolidified in the melting region 36 (after cooling or dissipation of warmth). The melting region 36 with the included elongated bubble 32 may usually clearly be identified, for example, with a light microscope, since its density and/or the refractive index has changed with respect to the surrounding material of the respective substrate (e.g., glass). In some cases, the area of nonlinear absorption 35 can also be observed as optical damage on the lower tip of the melting region 36.

Therefore, each laser spot and thus each laser weld line 6a, 6b, 6c, 6d is identifiable, for example by optical means, and therefore it may be assured that laser welding of the substrates has taken place. A single laser spot may also be referred to as heating zone 34.

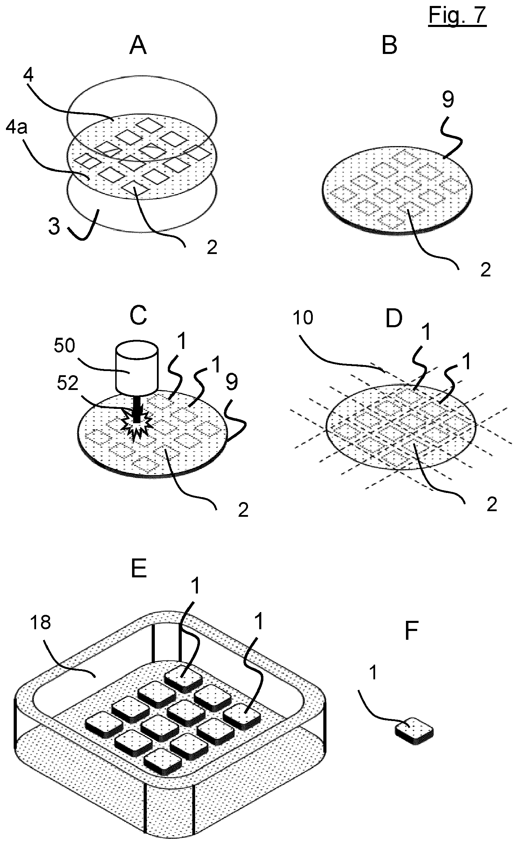

Referring now to Figure 7, a method of manufacturing an enclosure 1 is shown. In Step A, wafers 3, 4 and 4a are aligned on top of each other and a component 5 (not shown) to be sealed inside is arranged in the respective cavity 2. In Step B, the wafers are brought into optical contact and a waferstack 9 is provided. In the waferstack 9 as shown here, the first substrate 3 is in direct contact with the intermediate substrate 4a and the second substrate 4 is in direct contact with the intermediate substrate 4a.

In Step C, each enclosure 1 is laser-welded by means of a welding focus 52 generated by a welding laser source with focusing optics 50 introducing a laser weld line 6a, 6b, 6c, 6d in the enclosure 1, and hereby the cavities 2 are hermetically sealed. This step may therefore be called laser micro bonding of the cavity, or, of the enclosure 1. In Step D, the wafer stack 9 is diced (the enclosures are singulated) along the dicing lines 10. In Step E, singulated enclosures 1 are put in a bath or oven 18 to be heated above the threshold temperature, for example up to 85°C. Therefore, in Step E, the reduction zone 7 in the enclosure 1 is activated or reactivated. During heating of the singulated enclosures 1 a drying of the respective function zone 2 and/or cavity is achieved. In this process, during heating of the enclosure 1, pressure inside the cavity rises, whereas, due to the hermetically seal of each cavity 2, no gas may flow out easily out of the hermetically sealed cavity 2. The increase in cavity pressure improves absorption of said molecules, such as hydrogen, water or moisture, into the reduction zone 7. Therefore, in the embodiment shown in Figure 7, reduction of amount of said molecules (water, moisture or hydrogen) in the function zone 2 (e.g. provided as cavity 2) of the enclosure 1 is an active process, wherein a certain temperature range high enough to activate the reduction zone 7 and to increase absorption rate for said molecule content (hydrogen, water or moisture) into the reduction zone, but on the other side low enough to not affect or even destroy the functional element 5 situated in the cavity 2, is selected. For example, temperature to be chosen could be above 50°C, or above 75°C, for example 85°C and at the same time temperature to be chosen could be below 80°C or below 100°C or below 120°C in order to protect the functional element 5. Heating of the enclosures 1 in the oven 18 is continued until the moisture level inside the cavity 2 drops to 500 ppm or below, better to 250 ppm or below and even better to 100 ppm or below.

Activation of the reduction zone 7 may be performed prior to Step A as shown in Figure 7 in that the first and/or second substrate 3, 4 may be provided already activated for Step A. Activation of the surface may be done by means of polishing, dry or wet etching, dry or wet cleaning or plasma cleaning of the surfaces. There are cases where surfaces of a substrate 3, 4 may be provided activated even without additional activation step, for example when freshly produced glass is used as material for at least one of the substrates 3, 4, 4a, wherein OH groups are still unsaturated. These unsaturated OH groups may provide for a reduction capability and thus provide reduction zones 7 for a cavity 2. In other words, the reduction zone 7 provides for a rather low contact angle, preferably of 20 ° or less, or 10 ° or less, as described above.

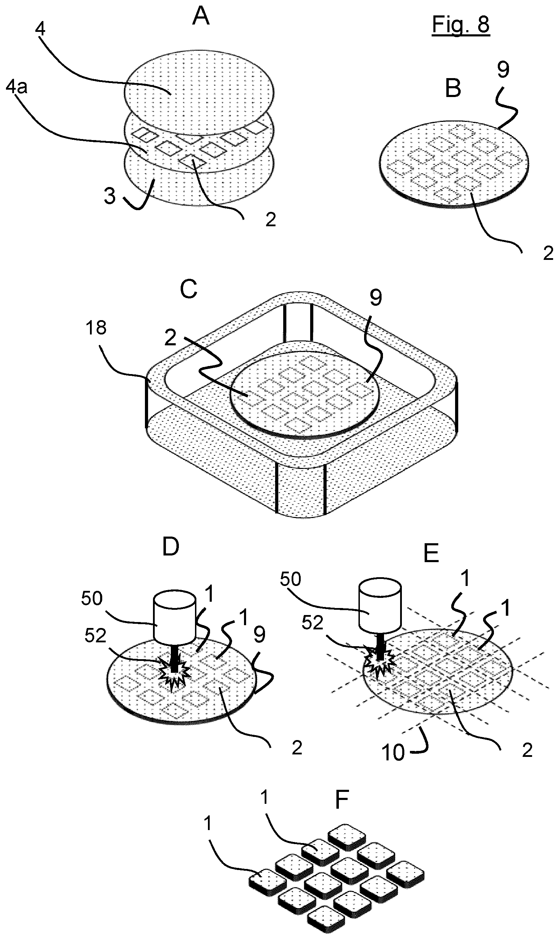

With respect to Figure 8, another embodiment of a method of manufacturing a multitude of enclosures 1 is shown, wherein in Step A the substrates 3, 4, 4a are aligned on top of each other. In Step B, the substrates 3, 4, 4a are brought into optical contact with each other, thereby providing a waferstack 9. Waferstack 9 is then put into the oven 18 and heated to above threshold temperature, for example to a temperature of 85°C. During heating of the enclosure in the oven 18, the reduction zone 7 at an inner side of substrate 3 or 4 is activated and, e.g., hydrogen, water or moisture is absorbed by means of said reduction zone 7 positioned on the inner side of first substrate 3 and/or second substrate 4. In other words, the reduction zone 7 may be provided in an activated state or may be activated prior to establishing the hermetical seal of the function zone 2 provided by introduction of at least one laser weld line.

In Step D, the enclosures 1 are laser-welded by means of welding laser focus 52 provided by laser source with focusing optics 50, whereby each cavity 2 of the respective enclosure 1 is hermetically sealed. In Step E, laser dicing of the wafer along dicing lines 10 is performed. Advantageously, the same laser generator 50 may be used as for laser welding the enclosures. By means of Step F, hermetically sealed and dried enclosures 1 are provided.

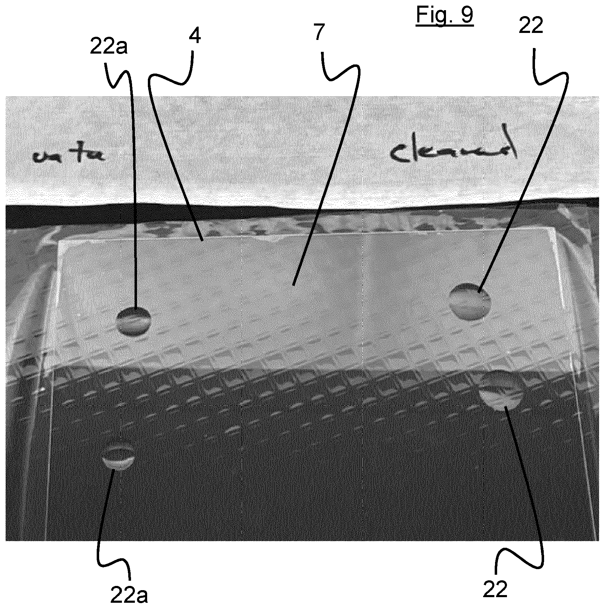

Referring now to Figure 9, the influence of activating the reduction zone is shown by means of positioning water droplets on different areas of the reduction zone 7. As can be seen, the two water droplets on the left side are not attracted by the surface they are put on. They are provided on a surface region of the reduction zone 7, which has not been activated, and therefore comprises a rather hydrophobic behavior. In contrast, the droplets on the right side 22 are provided on an activated region of the reduction zone 7, and it can be seen that the surface shows a rather hydrophilic behavior.

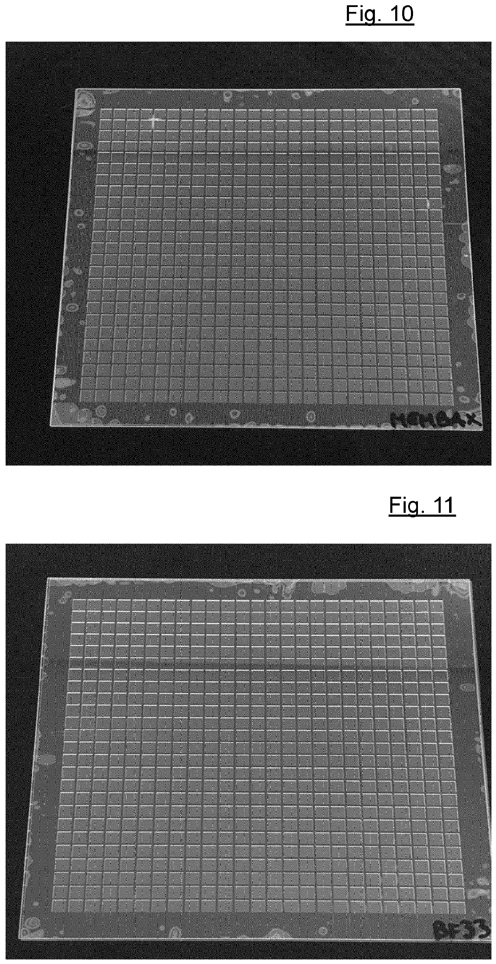

Referring now to Figures 10 and 11, two samples of a wafer comprising a multitude of enclosures is shown, where the reduction zone 7 is provided and the waferstacks 9 are just before performing the drying step for reducing the amount of moisture in the enclosures 1. Figure 10 shows enclosures 1 made from a MEMPAX wafer, Figure11 shows enclosures 1 made from a BF33 wafer.

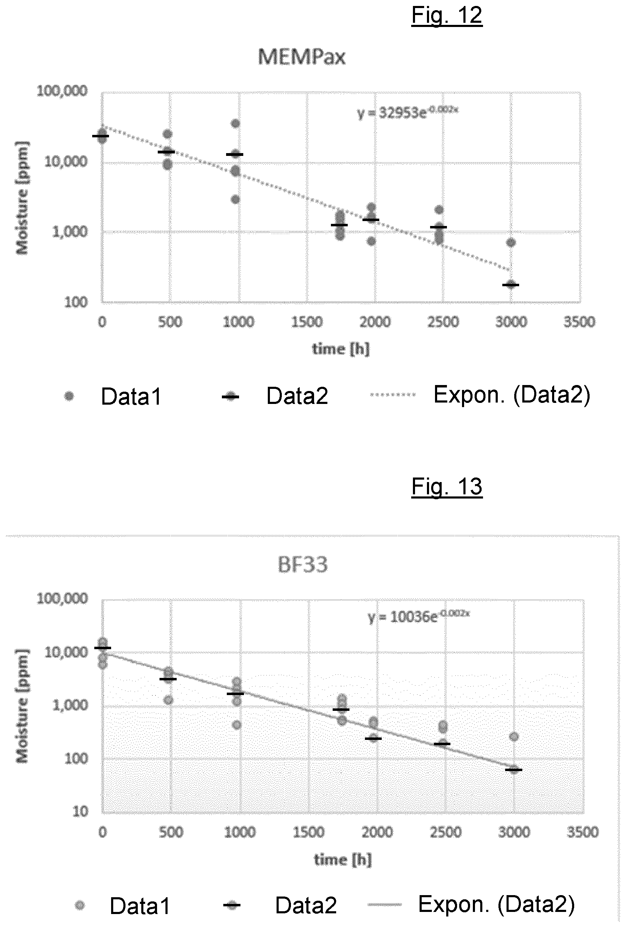

Figure 12 depicts the drying effect for the wafer 9 shown in Figure 10, where an initial moisture level of around 30,000 ppm was found and, after 3,000 hours of drying, a remaining moisture level of about 300 ppm was achieved. Figure13 shows the drying effect obtained with the wafer 9 shown in Figure 11, where, starting with an initial moisture level of about 10,000 ppm, after 3,000 hours of drying, a remaining moisture level of about 100 ppm could be achieved. This proves effectiveness and usability of the novel reduction zones 7 provided inside enclosures 1, in particular and preferably on at least one of the inner sides of first substrate 3 and/or second substrate 4 facing towards the cavity 2. This arrangement provides for a rather large area of the reduction zone 7 to be in contact with the cavity 2, thus increasing the reduction effect.

It will be appreciated that the features defined herein in accordance with any aspect of the present invention or in relation to any specific embodiment of the invention may be utilized, either alone or in combination with any other feature or aspect of the invention or embodiment. In particular, the present invention is intended to cover an enclosure 1 and/or a method of manufacturing an enclosure 1 configured to include any feature described herein. It will be generally appreciated that any feature disclosed herein may be an essential feature of the invention alone, even if disclosed in combination with other features, irrespective of whether disclosed in the description, the claims and/or the drawings.

It will be further appreciated that the above-described embodiments of the invention have been set forth solely by way of example and illustration of the principles thereof and that further modifications and alterations may be made therein without thereby departing from the scope of the invention.

### Reference list:

- 1: enclosure
- 2: function zone, such as a cavity
- 3: first substrate
- 4: second substrate
- 4a: further substrate, like intermediate substrate
- 5: functional element
- 6a: first laser weld line
- 6b: second laser weld line
- 6c: third laser weld line
- 6d: fourth laser weld line
- 7: reduction zone
- 7a, 7b: further reduction zones
- 9: wafer stack
- 10: dicing line
- 11: edge of glass stack / enclosure
- 12: rim
- 15: contact area
- 15a: second contact area
- 18: oven
- 22: water droplet provided on activated (hydrophilic) reduction zone 7
- 22a: water droplet provided on non-activated (hydrophobic) reduction zone 7
- 31: inner side of first substrate
- 32: elongated bubble
- 34: Heating zone
- 35: Area of nonlinear absorption
- 36: Melting region
- 37: lateral width of laser weld line
- 38: vertical height of laser weld line
- 41: inner side of second substrate
- 50: laser source with focusing optics
- 52: welding laser focus
- S1: separation spacing to outer surface of first substrate 3
- S2: separation spacing to outer surface of second substrate 4
- S3: separation spacing to rim 12

## Claims

1. Hermetically sealed enclosure (1), comprising:
at least a first substrate (3) and a second substrate (4),
a function zone (2) that is circumferentially enclosed in the enclosure,
wherein the second substrate is transparent at least in part and/or at least for a bandwidth of wavelengths,
at least one laser weld line (6a, 6b, 6c, 6d) to hermetically weld the substrates of the enclosure with each other and/or to hermetically seal the function zone,
at least one reduction zone (7, 7a, 7b) for reducing an amount of molecules such as gasses, or water in the function zone (2).

2. Hermetically sealed enclosure (1) according to the preceding claim, further comprising:
an inner surface (31) of the first substrate (3) and/or an inner surface (41) of the second substrate (4), each facing towards the function zone (2),
wherein the reduction zone (7, 7a, 7b) is arranged on said inner surface of the first substrate and/or of the second substrate, and/or
wherein the reduction zone (7, 7a, 7b) constitutes at least part of the inner surface of the first substrate and/or of the second substrate, and/or
wherein the reduction zone (7, 7a, 7b) comprises a part of the volume of the first substrate and/or of the second substrate including at least a part of the inner surface of the first substrate and/or of the second substrate.

3. Hermetically sealed enclosure (1) according to any of the preceding claims,
wherein the reduction zone (7, 7a, 7b) is comprised as a coating on the inner side of the first substrate and/or the second substrate, and/or
wherein the reduction zone (7, 7a, 7b) comprises an increased effective surface.

4. Hermetically sealed enclosure (1) according to the preceding claim,
wherein the reduction zone (7, 7a, 7b) comprises at least one of nano- and/or microstructures, porous glass, micro- and nanostructured glass surfaces, or a hydrophilic nano-coating.

5. Hermetically sealed enclosure (1) according to any of the preceding claims,
wherein the reduction zone (7, 7a, 7b) is designed such to absorb water vapor from the function zone (2), and/or
wherein the reduction zone (7, 7a, 7b) comprises unsaturated OH groups and/or
wherein the reduction zone (7, 7a, 7b) provides for a contact angle of 20° or less, preferably 10° or less.

6. Hermetically sealed enclosure (1) according to any of the preceding claims,
wherein the reduction zone (7, 7a, 7b) is designed to continuously reduce the amount of molecules such as gasses, hydrogen, water or moisture in the function zone, and/or
wherein the reduction zone (7, 7a, 7b) provides for a reduction rate of 0.5% or more per day, preferably 2 % per day or more of the amount.

7. Hermetically sealed enclosure (1) according to any of the preceding claims, being designed such that the reduction zone (7, 7a, 7b) may be regenerated or reactivated or activated by means of heating up the reduction zone and/or the enclosure above a threshold temperature, for example to 50 °C or higher, or to 75 °C or higher.

8. Hermetically sealed enclosure (1) according to any of the preceding claims,
wherein the reduction zone (7, 7a, 7b) is regenerated or reactivated or activated, for example by means of fire polishing, dry or wet etching, dry or wet cleaning or plasma cleaning e.g. of at least one of the inner side (31, 41) of the first and/or second substrate (3, 4), and/or
wherein regeneration or reactivation or activation of the reduction zone (7, 7a, 7b) increases its permeability for said molecules, and/or
wherein the reduction zone (7, 7a, 7b) is designed such that the laser weld line (6a, 6b, 6c, 6d) may pierce through the reduction zone.

9. Hermetically sealed enclosure (1) according to any of the preceding claims,
wherein the laser weld line (6a, 6b, 6c, 6d) comprises a series of laser dots in a sequence, and/or
wherein the laser weld line (6a, 6b, 6c, 6d) directly binds the first (3) and second substrate (4) to each other by means of a direct laser-induced welding process, and/or
wherein in the laser weld line (6a, 6b, 6c, 6d) material from the first substrate (3) is mixed into the second substrate (4) and/or material from the second substrate (4) is mixed into the first substrate (3), and/or
wherein in the laser weld line (6a, 6b, 6c, 6d) a convection zone (36) is present, where material from the first substrate (3) is mixed with material from the second substrate (4).

10. Hermetically sealed enclosure (1) according to any of the preceding claims,
wherein the laser weld line (6a, 6b, 6c, 6d) reaches both into the first substrate (3) and the second substrate (4), and/or
wherein the laser weld line (6a, 6b, 6c, 6d) comprises a mixture of material of the first substrate (3) and the second substrate (4), and/or
wherein the laser weld line (6a, 6b, 6c, 6d) comprises a height HL in a direction perpendicular to its connecting plane, and
wherein the laser weld line is situated with a height HL1 inside the first substrate (3) and with a height HL2 = HL - HL1 inside the second substrate (4)..

11. Hermetically sealed enclosure (1) according to any of the preceding claims,
wherein the function zone (2) is circumferentially surrounded by the reduction zone (7, 7a, 7b) arranged on the inner sides (31, 41) of the first (3) and second substrates (4), and/or
wherein the function zone (2) comprises at least one cavity, wherein, for example, at least one functional component (5) is arranged in the cavity, such as an electronics component, a MEMS or a MOEMS.

12. Hermetically sealed enclosure (1) according to any of the preceding claims,
wherein the first substrate (3) is, at least in a contact area (15, 15a), in direct contact with the second substrate (4), for example a two-dimensional contact area.

13. Hermetically sealed enclosure (1) according to any of the preceding claims,
wherein the reduction zone (7, 7a, 7b) is designed to reduce the molecule content, e.g. of hydrogen, water and/or moisture content, to 700 ppm or less, preferably to 500 ppm or less, further preferably 250 ppm or less, or even to 100 ppm or less, and/or
wherein the function zone (2) of the enclosure comprises 700 ppm or less of molecules, such as hydrogen, water and/or moisture content, preferably 500 ppm or less, further preferably 250 ppm or less, or even 100 ppm or less.

14. Use of a hermetically sealed enclosure (1) according to one of the preceding claims for making a medical implant, a wafer level packaged component, micro lens compound, a micro optical chip, a pharmaceutical packaging, a sensor such as a LIDAR sensor, or an LED device.

15. Method of providing a hermetically sealed enclosure (1), for example as claimed in any of the preceding claims, wherein the enclosure encloses a function zone (2), the method comprising the steps:
providing a first (3) and a second substrate (4),
preparing or providing a reduction zone (7, 7a, 7b) on or at the first substrate and/or the second substrate for reducing an amount of molecules such as hydrogen, water or moisture in the function zone,
aligning the first substrate with an inner side (31) at an inner side (41) of the second substrate,
hermetically sealing the function zone by means of introducing at least one laser weld line (6a, 6b, 6c, 6d) in the enclosure.

16. The method of providing a hermetically sealed enclosure (1) as claimed in the preceding claim, wherein the step hermetically sealing the function zone (2) comprises:
guiding a laser beam (52) from a laser beam source (50) such that the laser weld line (6a, 6b, 6c, 6d) is drawn around the function zone and in between the first substrate (3) and the second substrate (4) and/or such that it reaches both into the first substrate and the second substrate.

17. The method of providing a hermetically sealed enclosure (1) as claimed in any of the preceding method claims, wherein the laser weld line (6a, 6b, 6c, 6d) is drawn by means of a pulsed laser source (50), so that a continuous or a quasi-continuous weld line is composed from several laser pulses.

18. The method of providing a hermetically sealed enclosure (1) as claimed in any of the preceding method claims, after the step of hermetically sealing the function zone (2) further comprising the step
reducing the amount of molecules in the function zone to an amount of 700 ppm or less, preferably 500 ppm or less, more preferably 250 ppm or less, or even 100 ppm or less.

19. The method of providing a hermetically sealed enclosure (1) as claimed in any of the preceding method claims, further comprising the step
activating or reactivating or regenerating the reduction zone (7, 7a, 7b), and/or
heating the enclosure above a threshold temperature, for example above room temperature, or to a temperature above 50 °C, preferably to a temperature of 75 °C or more,
wherein any of the before-mentioned steps is preferably performed after the step of hermetically sealing the function zone.

20. The method of providing a hermetically sealed enclosure (1) as claimed in any of the preceding method claims, wherein the aligning step comprises
aligning the two substrates (3, 4, 4a) directly at each other such that the first substrate (3) is in direct contact with the second substrate (4), for example, where gapless contact between the first and second substrate is established and/or no other material is arranged in between the first substrate and the second substrate.

21. The method of providing a hermetically sealed enclosure (1) as claimed in any of the preceding method claims,
wherein at least the step of hermetically sealing the function zone by means of introducing at least one laser weld line (6a, 6b, 6c, 6d) in the enclosure is performed in a moisture containing atmosphere and/or a clean room with a moisture content in a range of about 1,000 ppm to 50,000 ppm of H2O molecules in the surrounding air.

22. Evacuated sealed enclosure (1) made by the method as claimed in any of the preceding method claims.
